# EUROPÄISCHE PATENTANMELDUNG

(11) **EP 1 703 277 A2**
(43) Veröffentlichungstag der Anmeldung: **20.09.2006**
(21) Anmeldenummer: 06013769.2
(22) Anmeldetag: 23.01.1997
(51) Int. Cl.: G01N 27/22

(54) **Feuchtesensor**

(30) Priorität: 06.02.1996 DE 19604259; 18.03.1996 DE 19610599
(62) Teilanmeldung aus: 97902211.8
(71) Anmelder: Liebherr-Mischtechnik GmbH, 88427 Bad Schussenried (DE)
(72) Erfinder: Frey, Werner, 88422 Oggelshausen (DE); Götz, German, 88525 Dürmentingen (DE)
(74) Vertreter: Laufhütte, Dieter

(57) **Zusammenfassung**

Die Erfindung betrifft einen Feuchtesensor zur kapazitiven Messung der in einem Material, vorzugsweise Schüttgut, enthaltenen Feuchte. Für den parallelen Betrieb mehrerer Feuchtesensoren muss ein einzelner Feuchtesensor besonders hohe Anforderungen in Bezug auf Genauigkeit, Empfindlichkeit und Austauschbarkeit erfüllen. Diese Anforderungen erfüllt der erfindungsgemäße Feuchtesensor dadurch, dass in dem Gehäuse eine digitale Recheneinheit angeordnet ist, die eine in einem digitalen Speicher abgelegte Kalibriertabelle zur Ermittlung von Feuchtewerten in Abhängigkeit von Meßsignalen einer die Kapazität des Streufeldkondensators messenden Kapazitätsmeßschaltung und von auf den Feuchtesensor einwirkenden Störgrößen aufweist.

## Beschreibung

Die Erfindung betrifft einen Feuchtesensor zur kapazitiven Messung der in einem Material, vorzugsweise Schüttgut, enthaltenen Feuchte nach dem Oberbegriff des Patentanspruchs 1.

Ein derartiger Feuchtesensor ist aus der Patentschrift DE 36 12 282 bekannt und dient dazu, die Feuchte eines über eine Prallplatte strömenden Schüttguts, das zuvor durch Abwurf auf die Prallplatte in seiner Dichte in reproduzierbarer und gleichbleibender Weise homogenisiert worden ist, zu messen. Der dabei verwendete Feuchtesensor ist in einem Kunststoffgehäuse mit einer Abschlußplatte untergebracht und derart an die Prallplatte befestigt, dass die Ebene der Gleitfläche der Prallplatte mit der Abschlußplatte fluchtet. Auf der dem Schüttgut abgewandten Seite der Abschlußplatte befindet sich ein Streufeldkondensator, dessen Kondensatorpole durch zwei konzentrische Drahtschleifen gebildet sind. Beim Anlegen einer elektrischen Spannung an die beiden Drahtschleifen bildet sich zwischen Drahtschleifen ein Streufeld aus, das die Abschlußplatte und das über die Abschlußplatte strömende Schüttgut durchdringt. Hierdurch wirkt das Schüttgut bezüglich des Streufeldes als Dielektrikum, dessen Dielektrizitätskonstante im wesentlichen von der Feuchte des Schüttguts abhängt. Da die geometrischen Verhältnisse des Streufeldkondensators konstant bleiben, kann angenommen werden, dass Änderungen in der Feuchte annähernd proportional zu Kapazitätsänderungen des Streufeldkondensators sind. Die Auswertung dieser Kapazitätsänderungen geschieht bei dem gattungsgemäßen Feuchtesensor dadurch, dass der Streufeldkondensator mit einer Festkapazität als Spannungsteiler verschaltet ist, wobei der Spannungsteiler durch eine hochfrequente Wechselspannung versorgt wird. An dem Streufeldkondensator entsteht somit eine feuchteabhängige Hochfrequenzspannung, die elektronisch weiterverarbeitet werden kann. Die Weiterverarbeitung geschieht dabei durch eine zentrale Auswerteeinheit, die mit dem Feuchtesensor über eine Verbindungsleitung verbunden ist.

Der Einsatz des oben beschriebenen Feuchtesensors hat sich insbesondere bei der Herstellung von Transportbeton als wichtig erwiesen, da die Betonqualität auch entscheidend von der Einhaltung des Wasser-Zement-Werts abhängt und sich dieser Wert nur zuverlässig bestimmen lässt, wenn die Feuchte der Zuschlagstoffe berücksichtigt wird. Besonders hohe Anforderungen an die Meßgenauigkeit und die Empfindlichkeit der verwendeten Feuchtesensoren werden dabei bei der Dosierung mehrerer Zuschlagstoffe gestellt, da die Ungenauigkeiten der einzelnen Feuchtesensoren sich dann addieren. Es hat sich gezeigt, dass in diesen Fällen die Genauigkeit und die Empfindlichkeit bekannter Feuchtesensoren nicht ausreicht, um hochwertigen Transportbeton herzustellen. Ein weiteres Problem bei dem parallelen Betrieb mehrerer Feuchtesensoren besteht weiterhin darin, dass die zentrale Auswerteeinheit mitunter nicht mehr in der Lage ist, die anfallenden Datenmengen auszuwerten. Außerdem ist der Austausch eines einzelnen Feuchtesensors in einer parallel arbeitenden Mischanlage sehr aufwendig, da hierzu der gesamte Mischbetrieb der Anlage unterbrochen werden muss, um den einzelnen Sensor neu zu kalibrieren.

Aufgabe der vorliegenden Erfindung ist es deshalb, einen Feuchtesensor der eingangs genannten Art zu schaffen, der die Anforderungen in Bezug auf Genauigkeit, Empfindlichkeit, Austauschbarkeit und Datenverarbeitung für einen parallelen Mischbetrieb erfüllt.

Die erfindungsgemäße Lösung der Aufgabe besteht darin, dass eine digitale Recheneinheit in dem Gehäuse angeordnet ist, die eine in einem digitalen Speicher abgelegte Kalibriertabelle zur Ermittlung von Feuchtewerten in Abhängigkeit von den Meßsignalen der Kapazitätsmeßschaltung und von auf den Feuchtesensor einwirkenden Störgrößen aufweist. Der besondere Vorteil dieser Lösung ist darin zu sehen, dass der Feuchtesensor unabhängig von einer zentralen Auswerteeinheit betrieben und kalibriert werden kann. Hierdurch ist es möglich, dass der Feuchtesensor bereits vor Inbetriebnahme kalibriert wird und somit gegen einen defekten Feuchtesensor ohne aufwendige Kalibriermaßnahmen vor Ort ausgetauscht werden kann. Außerdem kann durch die digitale Recheneinheit bereits eine Datenkomprimierung im Feuchtesensor stattfinden, so dass die zu der zentralen Auswerteeinheit zu übertragenden Datenmengen erheblich reduziert werden können.

Um eine Grundkalibrierung des Feuchtesensors vornehmen zu können, weist die Kalibriertabelle weitere Eingangsparameter auf, die aus den auf den Sensor wirkenden Störgrößen bestehen. Die wesentlichen Störgrößen sind dabei die Temperatur des Schüttguts und die Temperatur der Kapazitätsmeßschaltung, die ein Meßsignal in Abhängigkeit von der Kapazität des Streufeldkondensators liefert. In weiterer Ausgestaltung der Erfindung ist es deshalb vorgesehen, dass die auf der Kapazitätsmeßschaltung vorherrschende Temperatur mit einem ersten Temperatursensor meßbar ist, wobei die Temperatur der Kapazitätsmeßschaltung ein weiterer Eingangsparameter der Kalibriertabelle ist. Zweckmäßigerweise ist außerdem ein zweiter Temperatursensor vorgesehen, der die auf der Abschlußplatte vorherrschende Temperatur mißt, wobei die Temperatur der Abschlußplatte bzw. des Schüttguts ein weiterer Eingangsparameter der Kalibriertabelle ist.

Eine weitere zu berücksichtigende Störgröße sind Dichtestörungen des zu messenden Schüttguts, die sich aufgrund der Feuchtigkeit selbst ergeben. Als Beispiel hierfür ist das Anrühren eines Gipspulvers zu nennen, dessen Volumen schwindet, sobald dieses mit Wasser angerührt wird. Die Dichtestörungen sind materialspezifisch und ändern sich mit der Art des Schüttguts bzw. Materials. Um diese Störeinflüsse materialspezifisch berücksichtigen zu können, ist vorgesehen, dass die feuchtespezifische Dichte des Materials bzw. des Schüttguts vor dem Meßvorgang einmalig bestimmbar oder während des Meßvorgangs fortlaufend ermittelbar ist, wobei die feuchtespezifische Dichte des Materials bzw. des Schüttguts ein weiterer Eingangsparameter der Kalibriertabelle ist. Zweckmäßigerweise werden in die Recheneinheit Standardwerte üblicher Schüttgutsorten eingespeist, so dass entsprechend der Schüttgutqualität ein bestimmter zugehöriger Wert als Eingangsparameter in die Kalibriertabelle eingehen kann.

Um die auf der Kapazitätsmeßschaltung vorherrschende Temperatur in geeigneter Weise messen zu können, ist die Kapazitätsmeßschaltung zweckmäßigerweise auf einem Hybridschaltkreis mit einem gut wärmeleitfähigen Substrat aufgebracht. Als Substrat kann zum Beispiel Aluminiumoxid verwendet werden, das eine gute Temperaturleitfähigkeit besitzt, wodurch ein guter Temperaturübergang zwischen den temperaturabhängigen Halbleiterbauelementen und dem ersten Temperatursensor herstellbar ist.

Eine weitere bevorzugte Ausführungsform der Erfindung besteht darin, dass die Recheneinheit über eine Busleitung mit der zentralen Auswerteeinheit verbunden ist, wobei die zentrale Auswerteeinheit der Recheneinheit des Feuchtesensors Startbefehle erteilt und die ermittelten Feuchtewerte abruft. Um den Leitungsaufwand gering halten zu können, ist zweckmäßigerweise eine serielle Busleitung vorgesehen. Bei der Verwendung mehrerer Feuchtesensoren ist die zentrale Auswerteeinheit zweckmäßigerweise über die Busleitung mit den digitalen Recheneinheiten der einzelnen Feuchtesensoren verbunden, so dass ein paralleler Mischbetrieb mit mehreren Feuchtesensoren bei geringem Aufwand für die zu übertragenden Daten und die zu verlegenden Leitungen möglich ist. Beispielsweise können an die Busleitung bis zu 16 Feuchtesensoren angeschlossen sein.

Zweckmäßigerweise führt die in dem Feuchtesensor angeordnete digitale Recheneinheit eine Mittelung mehrerer Messungen durch, bevor ein Feuchtewert an die zentrale Auswerteeinheit übergeben wird. Befindet sich ein Feuchtesensor dabei unter einem Zuschlagsilo mit einem Grobauslauf und einem Feinauslauf, so werden zweckmäßigerweise die jeweiligen Feuchtemeßwerte entsprechend der Stellung des Grobauslaufs und des Feinauslaufs gewichtet. Da der Feinauslauf nach dem Schließen des Grobauslaufs lediglich zur Feindosierung dient, ist es zweckmäßig, die Meßwerte während des Feinauslaufs geringer als die Meßwerte während des Grobauslaufs zu wichten. Die Feindosierung kann auch dadurch geschehen, dass nur eine Auslaufklappe vorhanden ist, die zur Grobdosierung voll geöffnet und bei der Feindosierung nur zum Teil geöffnet ist. Wenn von der Grobdosierung auf die Feindosierung umgeschaltet wird, wird mit einer neuen Mittelwertbildung begonnen, so dass am Ende des Dosiervorgangs zwei Meßwerte von dem Feuchtesensor an die zentrale Auswerteeinheit übergeben werden. Der Definitionsbereich für die Meßwerte kann der digitalen Recheneinheit übergeben werden. Auf diese Weise können nicht relevante Werte oder Störspitzen ausgeblendet werden.

Weitere Einzelheiten und Vorteile der Erfindung werden anhand eines in der Zeichnung dargestellten Ausführungsbeispiels näher erläutert. In dieser zeigt:
- Figur 1:: eine Draufsicht einer Abschlußplatte mit aufgedampfter Metallschicht eines Feuchtesensors,
- Figur 2:: eine perspektivische Darstellung eines Feuchtesensors mit Flansch,
- Figur 3:: eine schematische Darstellung einer unter einem Zuschlagsilo angeordneten Prallplatte mit Feuchtesensor,
- Figur 4:: eine schematische Darstellung von mehreren in Prallplatten angeordneten Feuchtesensoren, die durch eine gemeinsame Busleitung mit einem zentralen Auswertegerät verbunden sind,

- Figur 5:: ein Blockschaltbild der Recheneinheit eines Feuchtesensors und
- Figur 6:: einen Schnitt durch eine Kalibriervorrichtung für einen Feuchtesensor.

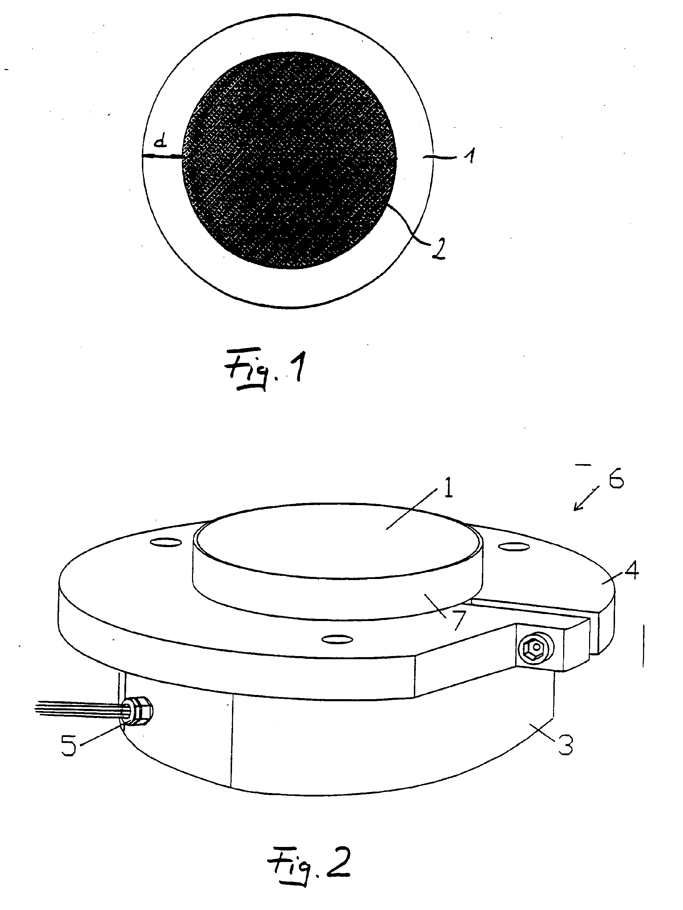

Figur 1 zeigt die Draufsicht einer Abschlußplatte 1 eines Feuchtesensors. Die Abschlußplatte 1 besteht aus einer Aluminiumoxid-Keramik und ist kreisrund ausgeführt. Konzentrisch dazu ist auf der dem Material bzw. Schüttgut abgewandten Seite eine Metallplatte 2 aufgedampft. Die Metallschicht 2 bildet dabei einen Pol des Kondensators, während der andere Pol durch das umgebende Gehäuse oder eine in der Ebene der Abschlußplatte liegende Prallplatte gebildet wird. Durch Versuche wurde herausgefunden, dass die Dicke der Abschlußplatte 1 sehr viel kleiner sein muss als der Abstand d zwischen dem äußeren Rand der Metallschicht 2 und dem äußeren Rand der Abschlußplatte 1.

Figur 2 zeigt eine perspektivische Darstellung eines Feuchtesensors 6. Das Gehäuse 3 des Feuchtesensors 6 wird durch einen Flansch 4 gehalten, der beispielsweise gegenüber einer Prallplatte verschraubt werden kann. Oberhalb des Flansches 4 befindet sich ein zylinderringförmiger Fortsatz 7, der durch die in Figur 1 abgebildete Abschlußplatte 1 stirnseitig geschlossen ist. Die mit der Metallschicht 2 versehene Seite der Abschlußplatte 1 zeigt dabei in das innere des Gehäuses 3. Unterhalb des Flansches ist ein Kabeleinlaß 5 vorgesehen. Das Gehäuse 3, der Flansch 4 und der zylinderförmige Fortsatz 7 bestehen aus rostfreiem Edelstahl.

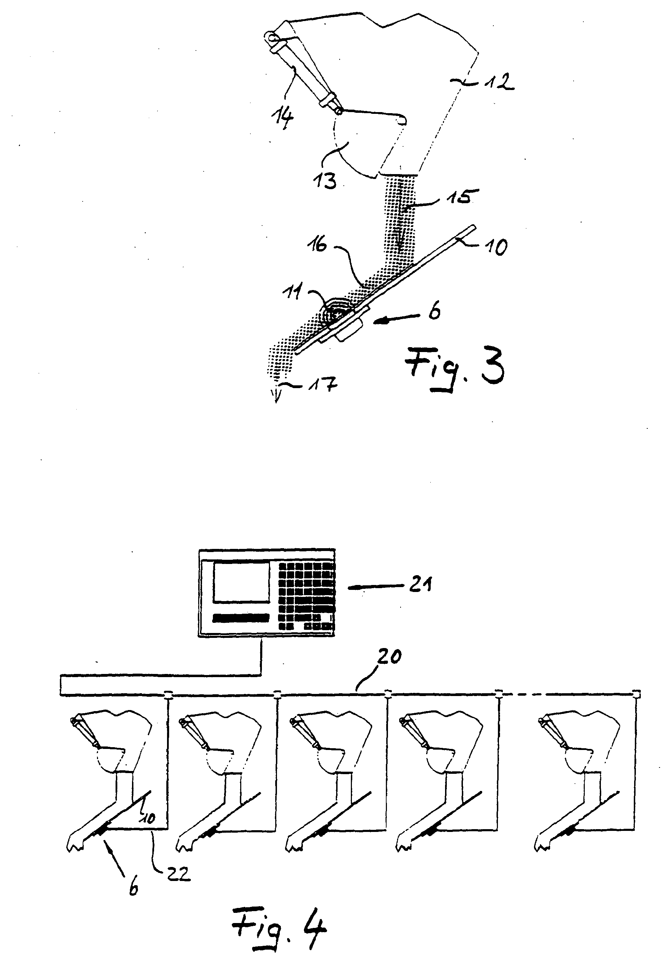

Figur 3 zeigt den Einbau eines Feuchtesensors 6 in eine Prallplatte 10. Die Prallplatte 10 befindet sich unter der Ausströmöffnung eines Zuschlagsilos 12. Die Ausströmöffnung des Zuschlagsilos 12 kann durch einen schwenkbaren Schieber 13 geöffnet und geschlossen werden, der über einen hydraulischen Stellzylinder 14 automatisch betätigt werden kann. Das aus der Öffnung des Silos austretende Schüttgut 15 trifft auf die Prallplatte 10 und wird von dieser in Richtung des Feuchtesensors 6 abgelenkt. Durch die Ablenkung bildet sich auf der Prallplatte 10 ein gleitender Gutstrom 16 mit reproduzierbarer Dichte und Geschwindigkeit aus. Der Feuchtesensor 6 ist so montiert, dass die Abschlußplatte 1 in einer Ebene der Prallplatte 10 montiert ist, so dass das von dem Feuchtesensor 6 erzeugte elektrische Streufeld 11 den gleitenden Gutstrom 16 durchdringen kann. Durch diese Anordnung kann die Volumenfeuchte in dem Schüttgut bestimmt werden. Da in dem gleitenden Gutstrom 16 weiterhin die Materialdichte annähernde konstant ist, ist die gemessene Volumenfeuchte proportional zu der Gewichtsfeuchte des Schüttguts. Die somit bestimmte Gewichtsfeuchte kann nun zur Berechnung einer Feuchtekorrektur zwischen Zuschlagstoff und Wasser herangezogen werden. Diese Korrektur findet in einem nicht näher dargestellten Wiegebehälter statt, in den das Schüttgut 15 in Richtung des Pfeils 17 weitergeleitet wird.

Figur 4 zeigt eine schematische Darstellung von mehreren in Prallplatten 10 angeordneten Feuchtesensoren 6, die parallel betrieben werden. Die Feuchtesensoren sind durch eine gemeinsame Busleitung 20 mit einer zentralen Auswerteeinheit 21 verbunden. Von jedem Feuchtesensor 6 zur Busleitung 20 führt ein Verbindungskabel 22, das an der Steckerbuchse 5 des Feuchtesensors 6 angeschlossen ist. Um den Leitungsaufwand gering zu halten, findet eine serielle Datenübertragung auf der Busleitung statt. Hierzu werden in der Busleitung 20 bzw. in dem Verbindungskabel 22 zwei Datenleitungen benötigt, außerdem wird durch zwei zusätzliche Leitungen der Feuchtesensor 6 mit Spannung versorgt.

Zur Durchführung einer Messung übermittelt die zentrale Auswerteeinheit 21 einen Startauftrag an den jeweiligen Feuchtesensor 6, dem eine entsprechende Adresse zugeordnet ist. Daraufhin startet die in dem Feuchtesensor angeordnete Recheneinheit eine Messung, wobei mehrere Meßwerte über die Zeit gemittelt werden. Ist die Messung abgeschlossen, wird der berechnete Feuchtewert an die zentrale Auswerteeinheit 21 als Ergebnis übergeben. Zusätzlich zum Feuchtewert können selbstverständlich auch weitere, bereits im Sensor aufbereitete Daten übertragen werden, wie zum Beispiel Temperaturen, Mittelwerte, Fehlermeldungen oder Meßstatus. Ferner kann der Startauftrag der zentralen Auswerteeinheit auch weitere Informationen enthalten, so dass die Messung gegebenenfalls parameterorientiert durchgeführt werden kann.

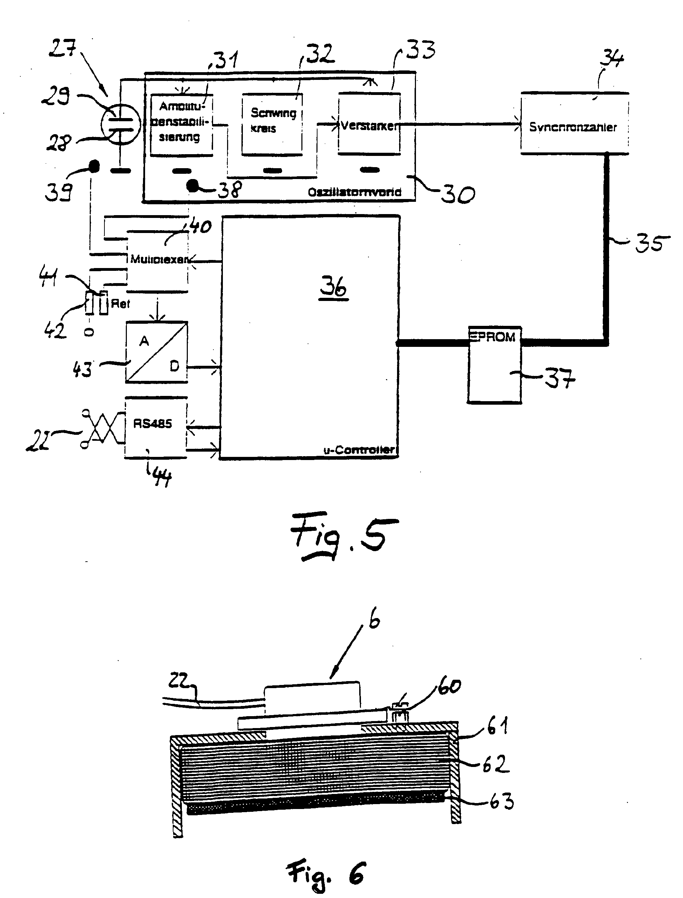

Figur 5 zeigt ein Blockschaltbild der Recheneinheit und den daran angeschlossenen Komponenten eines Feuchtesensors. Der Streufeldkondensator 27 wird durch einen gehäuseseitigen Pol 28 und einen sensorseitigen Pol 29 gebildet. Der gehäuseseitige Pol 28 wird durch das Gehäuse 3 bzw. die daran anschließende Prallplatte 10 gebildet und ist elektrisch mit Masse verbunden. Der sensorseitige Pol 29 ist mit der aufgedampften Metallschicht 2 verbunden. Bei Anlagen einer Spannung zwischen den Polen 28 und 29 bildet sich ein Streufeld des Streufeldkondensators 27 aus, wobei die Kapazitätsänderungen des Streufeldkondensators 27 aufgrund Feuchteänderungen des gleitenden Gutstroms 16 durch die Kapazitätsmeßschaltung 30 ausgewertet werden. Parallel zu dem Streufeldkondensator 27 ist ein Schwingkreis 32 bestehend aus einer Spule und einem weiteren Kondensator geschaltet. Der Schwingkreis 32 wird durch den Verstärker 33 gedämpft und schwingt auf dessen Resonanzfrequenz im Megaherzbereich. Die Amplitudenstabilisierung 31 hält dabei die Spannung am Streufeldkondensator 27 konstant. Hierdurch wird zum einen sichergestellt, dass der Verstärker 33 nicht übersteuert, zum anderen kann damit aber wirkungsvoll der Einfluß verschiedener Leitfähigkeiten des Schüttguts unterdrückt werden. Dies erklärt sich dadurch, dass die Leitfähigkeit des Schüttguts elektrisch gesehen einen Wirkwiderstand parallel zum Streufeldkondensator 27 darstellt, dessen Widerstandsänderung dann zu vernachlässigen ist, wenn die Spannung am Streufeldkondensator durch die Amplitudenstabilisierung 31 konstant gehalten wird. Das Ausgangssignal des Verstärkers wird einem Synchronzähler 34 zugeführt. Zur Steuerung des gesamten Auswertevorgangs ist ein Mikrocontroller 36 vorgesehen, dem über einen Multiplexer 40 und einem AD-Wandler 43 mehrere Meßsignale zugeführt werden können. Weiterhin weist der Mikrocontroller 36 eine Schnittstelle zu einem Schnittstellenbaustein 44 auf, an dem das Verbindungskabel 22 angeschlossen werden kann. An dem Bus 35 des Mikrocontrollers ist der Synchronzähler 34 sowie ein Eprom 37 angeschlossen.

Als Eingangssignal des Multiplexers 40 dienen die Meßsignale eines ersten Temperatursensors 38, eines zweiten Temperatursensors 39, einer Referenzspannungsquelle 41 und weiterer Meßsignale 42. Der erste Temperatursensor 38 mißt die Temperatur auf der Kapazitätsmeßschaltung 30, wobei die Kapazitätsmeßschaltung als Hybridschaltkreis realisiert ist. Als Substrat des Hybridschaltkreises wird ein Aluminiumoxid verwendet, durch dessen gute Wärmeleitfähigkeit eine zuverlässige Temperaturmessung des ersten Temperatursensors 38 gewährleistet ist. Der zweite Temperatursensor ist an der Abschlußplatte 1 angebracht und mißt die Temperatur der Abschlußplatte bzw. des auf der Abschlußplatte gleitenden Schüttguts. Über den Anschluß 42 können von dem Multiplexer 40 weitere Meßsignale, wie zum Beispiel die feuchtigkeitsspezifische Dichte eines Schüttguts, eingelesen werden. Der Multiplexer 40 wird von dem Mikrocontroller 36 getaktet und führt das jeweilige Multiplex-Signal einem AD-Wandler 43 zu, dessen digitaler Ausgangswert von dem Mikrocontroller 36 eingelesen wird.

Erhält der Mikrocontroller 36 über das Verbindungskabel 22 von der zentralen Auswerteeinheit 21 den Startbefehl für einen Meßauftrag, so wird der Zählerstand des Synchronzählers 34 über den Bus 35 auf Null gesetzt. Das Taktsignal des Verstärkers 22 bewirkt sodann ein Hochzählen des Synchronzählers 34, wobei der Zählerstand des Synchronzählers 34 die Anzahl der Resonanzschwingungen des Schwingkreises 32 über eine gewisse Zeit darstellt. Nach einer vorgegebenen Zeit, die über einen in dem Mikrocontroller 36 integrierter Timer ermittelt wird, wird der Synchronzähler 34 durch den Mikrocontroller 36 über den Bus 35 ausgelesen. Aus dem Zählerstand und der abgelaufenen Zeit kann die Frequenz des Schwingkreises 32 ermittelt werden, die ein Maß für die Kapazitätsänderung des Streufeldkondensators 27 ist. Zusammen mit den über den Multiplexer 40 eingelesenen Meßsignalen dient die errechnete Frequenz nun als Eingangsparameter für eine Kalibriertabelle, die vorher von dem Mikrocontroller aus dem Eprom 37 in dessen Arbeitsspeicher geladen wurde. Ausgangswert der Kalibriertabelle ist ein bestimmter Feuchtewert, der als Ergebnis von dem Mikrocontroller 36 über den Schnittstellenbaustein 44 und das Verbindungskabel 22 an die zentrale Auswerteeinheit 21 weitergeleitet wird. Gegebenenfalls kann auch eine Mittelung über mehrere Meßwerte erfolgen, bevor eine Meßwertübertragung zu der zentralen Auswerteeinheit 21 stattfindet.

Figur 6 zeigt einen Schnitt durch eine Kalibriervorrichtung für einen Feuchtesensor zum Erstellen einer in dem Eprom 37 abzuspeichernden Kalibriertabelle. Hierzu wird der Feuchtesensor 6 vor dessen Inbetriebnahme mittels eines Schnellspanners 60 auf einem Metallgehäuse 61 befestigt. Die Abschlußplatte 1 des Feuchtesensors liegt dabei auf einer Materialprobe mit bekannten dielektrischen Eigenschaften auf. Aufgrund der bekannten dielektrischen Eigenschaften der Materialprobe kann die Kalibriertabelle in Abhängigkeit der bei dem Multiplexer 40 eingehenden Meßsignale erstellt werden. Hierzu wird der auf dem Metallgehäuse 21 festgespannte Feuchtesensor zunächst auf die niedrigste zulässige Betriebstemperatur abgekühlt, also beispielsweise auf -10°. Sodann erfolgt eine Aufheizung des Feuchtesensors auf die höchste zulässige Betriebstemperatur, mittels einer Heizplatte 63, die unter der Materialprobe 62 angebracht ist. Beim Durchfahren dieser Temperaturspanne werden nun in Abhängigkeit der Meßsignale des ersten Temperatursensors 38, des zweiten Temperatursensors 39 sowie weiterer Meßsignale Kalibrierwerte für eine bestimmte Feuchte bei gegebener Frequenz des Schwingkreises 32 abgespeichert. Die derart erstellte Kalibriertabelle wird zusammen mit dem Steuerprogramm des Mikrocontrollers in dem Eprom 37 abgelegt, dessen Inhalt beim Hochlauf des Mikrocontrollers in dessen Arbeitsspeicher geladen wird.

Wird während des Aufheizvorgangs die Heizung 63 stets mit maximaler Leistung betrieben, so steigt die Temperatur im Inneren des Feuchtesensors 6 exponentiell an und nähert sich immer langsamer dem Endwert. Ein derartiger Temperaturanstieg hat den Nachteil, dass am Anfang des Temperaturanstiegs eine schnelle Abtastung der Meßwerte aufgrund der starken Änderungen erfolgen muss, während zum Ende des Meßvorgangs hin sich die Meßwerte nur langsam ändern und somit bei gleicher Abtastrate unnötig viele Meßpunkte aufgenommen werden. Deshalb kann es besonders vorteilhaft sein, die Heizung mit einer zusätzlichen Regelung zu versehen, die sicherstellt, dass die Temperaturdifferenz zwischen dem ersten und dem zweiten Temperatursensor konstant bleibt. Da der erste Temperatursensor sich im inneren des Gehäuses 3 des Feuchtesensors 6 befindet, während der zweite Temperatursensors am Gehäuse selber befestigt ist, wird durch die konstante Temperaturdifferenz zwischen beiden Temperatursensoren ein konstanter Wärmestrom vom Äußeren des Gehäuses in das Innere sichergestellt. Hierdurch erfolgt auch ein annähernd konstanter Temperaturanstieg im Inneren des Gehäuses, der eine wesentlich bessere Aufnahme der Kalibrierwerte ermöglicht.

## Patentansprüche

1. Feuchtesensor zur kapazitiven Messung der in einem Material, vorzugsweise Schüttgut, enthaltenen Feuchte,
mit einem Gehäuse, das eine nichtleitende Abschlußplatte aufweist, deren Außenseite auf das Material bzw. Schüttgut gerichtet ist oder über die sich das Material bzw. Schüttgut bewegt,
mit einem Gehäuse angeordneten Streufeldkondensator zur Erzeugung eines elektrischen Streufeldes, dessen Feldlinien die Abschlußplatte und das Material bzw. Schüttgut durchdringen
und mit einer Kapazitätsmeßschaltung, die ein Meßsignal in Abhängigkeit von der Kapazität des Streufeldkondensators liefert,
**dadurch gekennzeichnet,**
**daß** eine digitale Recheneinheit in dem Gehäuse angeordnet ist, die eine in einem digitalen Speicher angelegten Kalibriertabelle zur Ermittlung von Feuchtewerten in Abhängigkeit von den Meßsignalen der Kapazitätsmeßschaltung und von auf den Feuchtesensor einwirkenden Störgrößen aufweist.

2. Feuchtesensor nach Anspruch 1, **dadurch gekennzeichnet, daß** die auf der Kapazitätsmeßschaltung vorherrschende Temperatur mit einem ersten Temperatursensor meßbar ist, wobei die Temperatur der Kapazitätsmeßschaltung ein weiterer Eingangsparameter der Kalibriertabelle ist.

3. Feuchtesensor nach Anspruch 2, **dadurch gekennzeichnet, daß** die Kapazitätsmeßschaltung auf einem Hybridschaltkreis mit einem gut wärmeleitfähigen Substrat aufgebracht ist und daß der erste Temperatursensor die Temperatur des Substrats mißt.

4. Feuchtesensor nach einem der Ansprüche 2 bis 3, **dadurch gekennzeichnet, daß** die auf der Abschlußplatte vorherrschende Temperatur mit einem zweiten Temperatursensor meßbar ist, wobei die Temperatur der Abschlußplatte ein weiterer Eingangsparameter der Kalibriertabelle ist.

5. Feuchtesensor nach einem der Ansprüche 2 bis 4, **dadurch gekennzeichnet, dass** die feuchtespezifische Dichte des Materials bzw. des Schüttguts vor dem Meßvorgang einmalig bestimmbar oder während des Meßvorgangs fortlaufend ermittelbar ist, wobei die feuchtespezifische Dichte des Materials bzw. Schüttguts ein weiterer Eingangsparameter der Kalibriertabelle ist.

6. Feuchtesensor nach einem der Ansprüche 2 bis 5, **dadurch gekennzeichnet, daß** die Recheneinheit über eine Busleitung mit einer zentralen Auswerteeinheit verbunden ist, die der Recheneinheit des Feuchtesensors Strafbefehle erteilt und die ermittelten Feuchtewerte abruft.

7. Feuchtesensor nach Anspruch 6, **dadurch gekennzeichnet, daß** die zentrale Auswerteeinheit über die Busleitung mit den Recheneinheiten mehrerer Feuchtesensoren verbunden ist.
